Europäisches Patentamt

European Patent Office

Office européen des brevets

(19)

(11) Publication number: **0 033 028**
**B1**

(12) # EUROPEAN PATENT SPECIFICATION

(45) Date of publication of patent specification: **27.07.83**

(51) Int. Cl.³: **H 01 L 27/08, H 01 L 29/10**

(21) Application number: **80303928.8**

(22) Date of filing: **05.11.80**

(54) **A semiconductor integrated circuit device.**

(30) Priority: **09.11.79 JP 155320/79**

(43) Date of publication of application:
**05.08.81 Bulletin 81/31**

(45) Publication of the grant of the patent:
**27.07.83 Bulletin 83/30**

(84) Designated Contracting States:
**DE FR GB NL**

(56) References cited:
**DE - A - 2 458 226**
**US - A - 3 731 161**
**US - A - 3 858 061**
**US - A - 4 118 642**
**US - A - 4 156 939**

**IBM TECHNICAL DISCLOSURE BULLETIN, vol.
12, no. 9, February 1970 NEW YORK (US)
R. H. DENNARD: "Variation in threshold voltage
using reduced sourcedrain spacing"**

(73) Proprietor: **FUJITSU LIMITED
1015, Kamikodanaka Nakahara-ku
Kawasaki-shi Kanagawa 211 (JP)**

(72) Inventor: **Hino, Youzi
No. 1131, Miyauchi Nakahara-ku
Kawasaki-shi Kanagawa, 211 (JP)**
Inventor: **Kikuchi, Hideo
No. 2644-A-305, Eda-cho Midori-ku
Yokohama-shi Kanagawa, 227 (JP)**

(74) Representative: **Bedggood, Guy Stuart et al,
Haseltine Lake & Co. Hazlitt House 28
Southampton Buildings Chancery Lane
London WC2A 1AT (GB)**

# A semiconductor integrated circuit device

The present invention relates to a semiconductor integrated circuit device.

In previous semiconductor integrated circuit devices using MOS transistors, input circuits and internal circuits are constituted by transistors of the same channel length. There has been a growing tendency for this channel length to be reduced to meet the requirements for enhanced integration density. At reduced channel lengths, a transistor threshold voltage Vth and transistor amplification factor $\beta$ are subject to great variation with changes in channel length, and accordingly variations in transistor size introduced during manufacture have a marked effect on transistor threshold voltage Vth and transistor amplification factor $\beta$. Such effect is not critical in relation to internal circuits but in input circuits results in reduced noise margin for high and low levels of input signals thereto and hence is not desirable.

This will be described in connection with a case where a first stage of an input circuit is constituted, for example, by a CMOS inverter. A CMOS circuit is formed by a combination of a P-channel MOS transistor, in which carriers contributing to conduction are holes, and an N-, channel MOS transistor, in which carrier contributing to conduction are electrons.

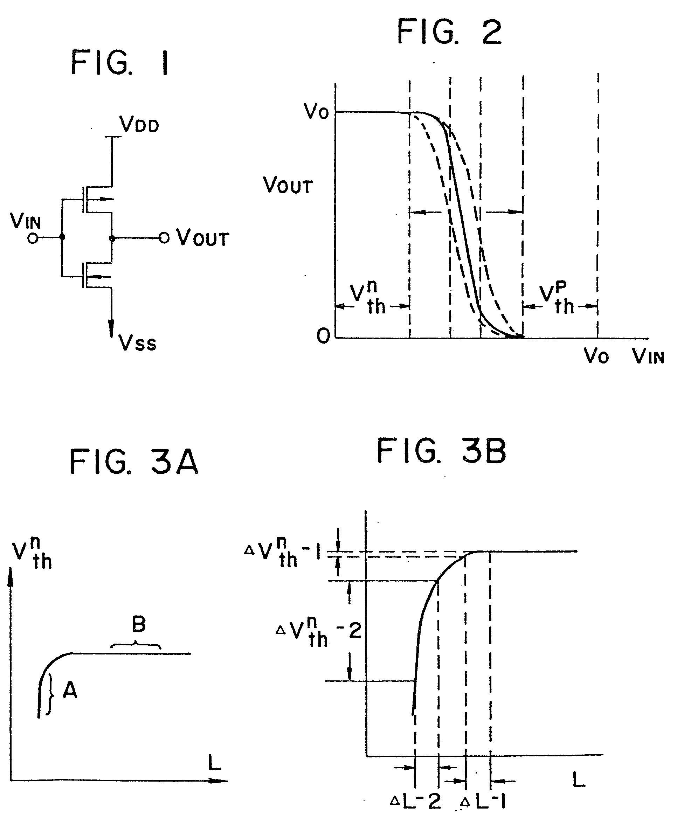

Fig. 1 of the accompanying drawings shows a CMOS input inverter circuit and Fig. 2 of the accompanying drawings is a graph showing its input-output voltage transfer characteristic.

In Fig. 2, when $V_{IN} < V^n th$ ($V_{IN}$ being an input voltage to the inverter circuit of Fig. 1, $V^n th$ a threshold voltage of the N-channel transistor of the circuit of Fig. 1 and $V^p th$ a threshold voltage of the P-channel transistor of the circuit of Fig. 1), the N-channel transistor is turned OFF and the P-channel transistor is turned ON, resulting in an output voltage $V_{OUT}$ of the inverter circuit of Fig. 1 becoming about $V_0$ volt. When $V^n th < V_{IN} < V_0 - V^p th$, the N-channel and P-channel transistors are both turned ON, permitting a DC current to flow between $V_{DD}$ and $V_{SS}$. Further, when $V_{In} > V_0 - V^p th$, the N-channel transistor is turned ON and the P-channel transistor is turned OFF, providing an output voltage of about 0 volt.

For example, in a case where the first stage of an input circuit is constituted by a CMOS inverter, the threshold voltage $V_T$ of the inverter as such as given as follows:

$$V_T = V_{DD} \times \frac{\sqrt{\beta_R}}{1 + \sqrt{\beta_R}} + V^n th \times \frac{1}{1 + \sqrt{\beta_R}} - \left| V^p th \right| \times \frac{\sqrt{\beta_R}}{1 + \sqrt{\beta_R}}$$

where $V_{DD}$ is a power source voltage, $V^n th$ is the threshold voltage Vth of the N-channel transistor of the inverter, $V^p th$ is the threshold voltage Vth of the P-channel transistor of the inverter and $\beta_R = \beta_P/\beta_N$, where $\beta_P$ is the amplification factor of the P-channel transistor of the inverter and $\beta_N$ is the amplification factor of the N-channel transistor of the inverter (refer to R. H. Crawford, "MOSFET in Circuit Design", McGraw-Hill, 1967).

In the above expression, $\beta$ is a constant dependent on the kind and thickness of a gate insulator, the impurity concentration in a semiconductor substrate, the potential difference between the source and the substrate and the size of the gate; usually, this constant is expressed as $\beta = \mu\varepsilon W/toxL$, where L is the channel length, W is the channel width, $\varepsilon$ is the dielectric constant of a gate oxide film, tox is the thickness of the gate oxide film and $\mu$ is the carrier mobility in a channel.

The high and low levels of such an input circuit depend on the amplification factor $\beta$ and the threshold voltage Vth of the P-channel transistor and of the N-channel transistor. The characteristic curve in Fig. 2 moves to the right (in the direction in which the power source voltage $V_{DD}$ rises) with an increase in the threshold voltage $V^n th$ or the amplification factor $\beta_P$ and moves to the left with an increase in the threshold voltage $V^p th$ or the amplification factor $\beta_N$. As transistor channel length is reduced, it becomes difficult to control the threshold voltages $V^n th$ and $V^p th$ and the amplification factors $\beta_N$ and $\beta_P$ so that a required threshold voltage $V_T$ of the input inverter circuit as such may be achieved in the aforesaid expression.

According to the present invention there is provided a semiconductor integrated circuit device, including MOS transistors, having an input circuit and an internal circuit, characterised in that the channel length of a first-stage transistor of the input circuit is greater than the channel lengths of transistors of the internal circuit.

An embodiment of the present invention can provide a semiconductor integrated circuit device built up of MOS transistors and in which the channel length of a transistor forming an inverter at the first stage of an input circuit of the device is selected to be larger than the channel lengths of transistors making up an internal circuit of the device, thereby to provide for improved noise margin.

Reference is made, by way of example, to the accompanying drawings, in which:—

Fig. 1 shows a CMOS inverter circuit;

Fig. 2 is a graph showing the input/output transfer characteristic of the CMOS inverter circuit of Fig. 1;

Fig. 3A is a graph showing the relationship between channel length L and N-channel threshold voltage $V^n$th;

Fig. 3B is a graph explanatory of the channel reduction effect in relation to threshold voltage $V^n$th;

Fig. 4A is a graph showing the relationship between channel length L and the P-channel threshold voltage $V^p$th;

Fig. 4B is a graphical plot of experimentally measured data relating to channel length and P-channel threshold voltage $V^p$th;

Fig. 5A is a graph showing the relationship between channel length L and amplification factor $\beta$;

Fig. 5B is a graph showing the relationship of amplification factor $\beta$ to channel length L (in a case in which the amplification factor $\beta$ of a transistor having a 1-$\mu$m channel length is selected to be 1.);

Fig. 6 is a graph showing the relationship between the channel length L and the threshold voltage Vth, using a drain voltage Vd as a parameter; and

Fig. 7 is a schematic diagram explanatory of an embodiment of the present invention.

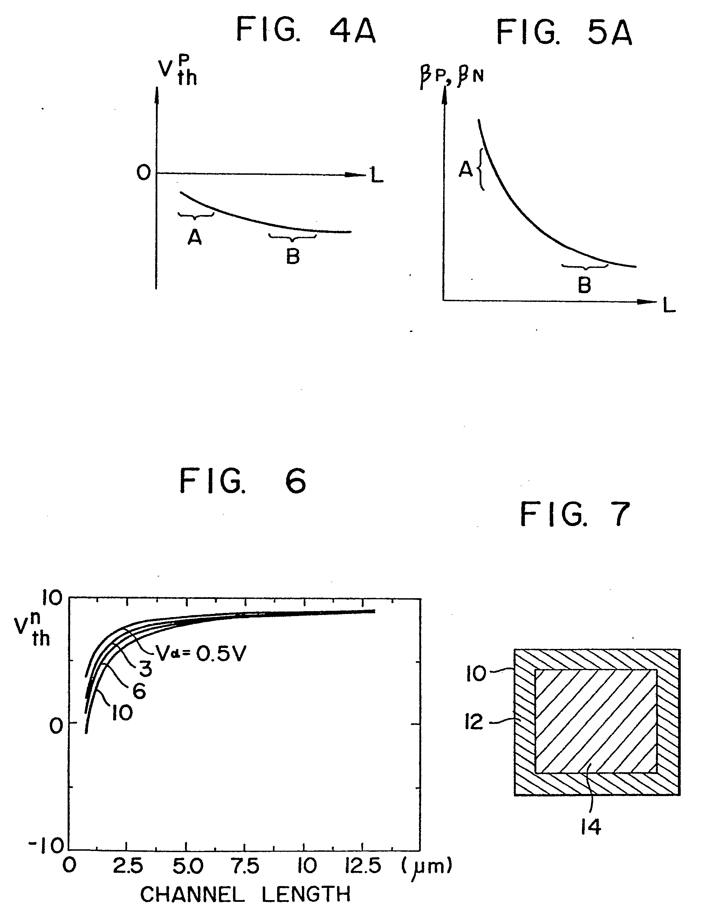

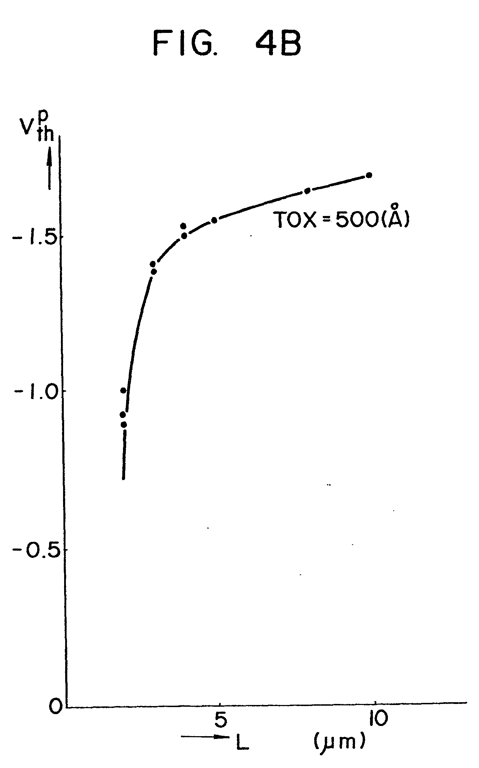

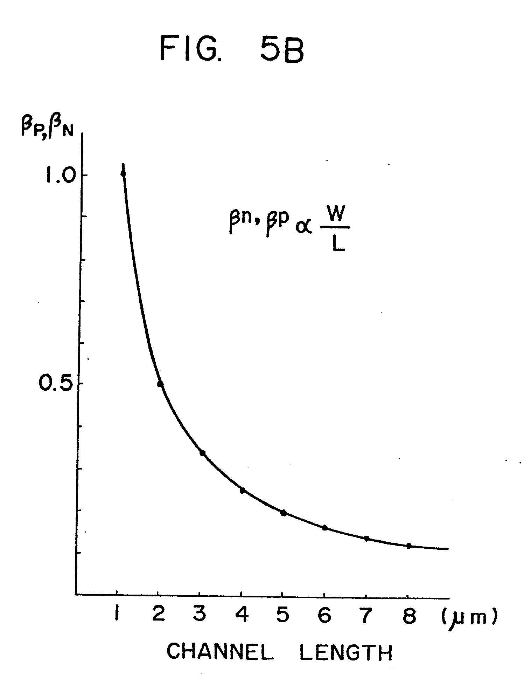

Figs. 3A, 3B and 4B are explanatory of the relationship between threshold voltages $V^n$th and $V^p$th and channel length L, and Fig. 5A shows the relationships of between amplification factors $\beta_P$ and $\beta_N$ and channel length L.

In the characteristic curves of the Figures, the changing ratios of the threshold voltages and the amplification factors abruptly rise (that is the rates of change of threshold voltages and amplification factors with respect to channel length increase abruptly) when channel length becomes small (that is, less than 2 to 3 $\mu$m). This physical phenomenon is known as a short channel effect.

The threshold voltage Vth and the amplification factor $\beta$ of a transistor having a channel about 3 $\mu$m long usually lie in the vicinity of the boundary between a large changing ratio (large rate of change) region A and a small changing ratio (small rate of change) region B in Figs. 3A, 4A and 5A.

A problem resulting from the abrupt reduction of the threshold voltages $V^n$th and $V^p$th (for short channel lengths) is dispersion in the input-output transfer characteristic of individual transistors. Fig. 3B is explanatory of the changing ratio of the threshold voltage Vth (that is, the rate of change of the threshold voltage with respect to channel length) showing on an enlarged scale the characteristic curve of Fig. 3A. In Fig. 3B, assuming that a change $\Delta$L—1 in channel length is 0.5 $\mu$m in the case in which the channel is long, the resultant variation in the threshold voltage $V^n$th is small is indicated by $\Delta V^n$th—1, whereas when a change $\Delta$L—2 is 0.5 $\mu$m in the case in which channel length is small, the variation in the threshold voltage $V^n$th is large as indicated by $\Delta V^n$th—2. Figs. 3A and 3B show characteristic curves generally explanatory of the relationships between the channel length L and the threshold voltage $V^n$th, and Fig. 6 shows calculated threshold voltage $V^n$th vs. channel length (or source-drain spacing) for different drain-to-source voltage characteristics (based on calculation by H. S. Lee). It will be understood from Fig. 6 that the aforementioned short channel effect becomes marked as the channel length decreases.

Fig. 4B illustrates experimental data showing the relationship between the channel length L and the threshold voltage $V^p$th, measured in the case where the thickness of the gate oxide film tox was 500 Å. It will be seen from Fig. 4B that abrupt change (high rate of change) in the threshold voltage $V^p$th becomes marked when the channel length L is small.

Fig. 5B illustrates data showing the relationship of amplification factor $\beta$ to the channel length L in relation to a case in which the amplification factor of a transistor having a 1-$\mu$m channel length was selected to be 1. Also in this case, it will be appreciated that the amplification factors $\beta_P$ and $\beta_N$ change abruptly as the channel length L is reduced. It is desirable, of course, that the variations in the threshold voltages $V^n$th and $V^p$th and the amplification factors $\beta_N$ and $\beta_P$ be kept small even if the channel length L is small (i.e. variations from one transistor to another as a result of manufacturing tolerances).

In an embodiment of the present invention, an inverter at the first stage of an input circuit of a semiconductor integrated circuit device is formed by transistors each of which has a large channel length, i.e. the channel length which is located in a sufficiently low changing ratio region (a region in which rate of change of threshold voltage or amplification factor with respect to channel length is sufficiently small) to reduce the variation in the threshold voltage $V_T$ of the circuit, thus ensuring that the high and low levels of the input circuit are guaranteed. Fig. 7 illustrates an embodiment of the present invention. In Fig. 7, reference numeral 10 indicates a semiconductor substrate; 12 designates a transistor group of an I/O circuit provided on peripheral portions of the substrate 10; and 14 identifies transistors of various logic or memory elements provided in the substrate body. The channel length of a first-stage transistor of the input stage in the transistor group mounted on the peripheral area of the substrate is selected to be larger than the channel lengths of the transistors forming the logic or memory elements.

An increase in the gate length decreases the amplification factor $\beta$ but suppresses variations in the threshold voltage Vth and the amplification factor $\beta$ to improve the noise margin for an input circuit. Even if the amplification factor $\beta$ of

the first-stage transistor is decreased, thereby reducing its driving performance (The first-stage transistor is usually equipped with a large gate width to enhance its driving performance, but even if the driving performance is reduced as a result of the increased channel length), this can be compensated for in the next-stage inverter.

Further, the large channel length of only the first-stage transistor of the input circuit, as compared with the channel length used in the internal circuit, does not seriously degrade integration density. It is a matter of course that an unrestricted extension of the channel length of the first-stage transistor of the input circuit leads to an increase in the space occupied by the transistor and hence is not to be preferred.

Thus, it will be apparent that provision of a relatively long channel in a first-stage transistor of an input circuit, and/or an increase in gate length, (as compared with internal circuit transistors) can provide the desired effect of suppressing problems caused by manufacturing tolerances in relation to provision of improved noise margin, reliable threshold voltage values and amplification factors, and reliable high and low input circuit levels.

**Claims**

1. A semiconductor integrated circuit device, including short channel MOS transistors, having an input circuit and an internal circuit, characterised in that the channel length of a first-stage transistor of the input circuit is greater than the channel lengths of transistors of the internal circuit.

2. A device as claimed in claim 1, wherein the said first-stage transistor is a transistor of a first-stage inverter of the input circuit.

3. A device as claimed in claim 2, wherein the said first-stage inverter is a CMOS inverter having a P-channel transistor and an N-channel transistor.

4. A device as claimed in any preceding claim, wherein the said internal circuit comprises memory and/or logic elements.

5. A device as claimed in any preceding claim, wherein the input circuit is disposed in the periphery of a semiconductor substrate of the device.

**Patentansprüche**

1. Integrierte Halbleiterschaltungsvorrichtung, die MOS-Transistoren mit kurzen Kanälen enthält, mit einer Eingangsschaltung und mit einer Innenschaltung, dadurch gekennzeichnet, daß die Kanallänge eines Transistors der ersten Stufe der Eingangsschaltung größer als die Kanallängen der Transistoren der Innenschaltung ist.

2. Vorrichtung nach Anspruch 1, bei welcher der Transistor der ersten Stufe ein Transistor eines Inverters der ersten Stufe der Eingangsschaltung ist.

3. Vorrichtung nach Anspruch 2, bei welcher der Inverter der ersten Stufe ein CMOS-Inverter mit einem p-Kanal-Transistor und einem n-Kanal-Transistor ist.

4. Vorrichtung nach einem vorangehenden Anspruch, bei welcher die Innenschaltung Speicher- und/oder logische Elemente enthält.

5. Vorrichtung nach einem vorangehenden Anspruch, bei welcher die Eingangsschaltung am Umfang eines Halbleitersubstrats der Vorrichtung angeordnet ist.

**Revendications**

1. Un dispositif à circuit intégré semiconducteur comprenant des transistors MOS à canal court, ayant un circuit d'entrée et un circuit interne, caractérisé en ce que la longueur de canal d'un transistor du premier étage du circuit d'entrée est supérieure aux longueurs de canal des transistors du circuit interne.

2. Un dispositif tel que revendiqué dans la revendication 1, dans lequel le transistor du premier étage est un transistor d'un inverseur du premier étage du circuit d'entrée.

3. Un dispositif tel que revendiqué dans la revendication 2, caractérisé en ce que l'inverseur du premier étage est un inverseur CMOS ayant un transistor à canal P et un transistor à canal N.

4. Un dispositif tel que revendiqué dans n'importe quelle revendication précédente, dans lequel le circuit interne comprend des éléments de mémoire et/ou des éléments logiques.

5. Un dispositif tel que revendiqué dans n'importe quelle revendication précédente, dans lequel le circuit d'entrée est placé à la périphérie d'un substrat semiconducteur du dispositif.

# FIG. 1

$V_{DD}$

$V_{IN}$ o——

o $V_{OUT}$

$V_{SS}$

# FIG. 2

$V_0$

$V_{OUT}$

0

$V_{th}^n$

$V_{th}^P$

$V_0$   $V_{IN}$

# FIG. 3A

$V_{th}^n$

B

A

L

# FIG. 3B

$\Delta V_{th}^n - 1$

$\Delta V_{th}^n - 2$

L

$\Delta L - 2$   $\Delta L - 1$

# FIG. 4A

# FIG. 5A

# FIG. 6

CHANNEL LENGTH

# FIG. 7

2

# FIG. 4B

TOX = 500(Å)

# FIG. 5B

$$\beta_n, \beta_p \propto \frac{W}{L}$$